# EUROPEAN PATENT APPLICATION

(11) **EP 4 715 522 A1**
(43) Date of publication of application: **25.03.2026**
(21) Application number: 24818353.5
(22) Date of filing: 02.04.2024
(51) Int. Cl.: G06F 1/20

(54) **COMPUTING EQUIPMENT BASED ON PHASE-CHANGE LIQUID COOLING TECHNOLOGY**

(30) Priority: 09.06.2023 CN 202310684677; 31.08.2023 CN 202311117502
(71) Applicant: Huawei Cloud Computing Technologies Co., Ltd., Guiyang, Guizhou, 550025 (CN)
(72) Inventor: CAO, Hanwen, Shenzhen, Guangdong 518129 (CN); GUO, Haowen, Shenzhen, Guangdong 518129 (CN); ZOU, Henglong, Shenzhen, Guangdong 518129 (CN); YAO, Xidong, Shenzhen, Guangdong 518129 (CN); CHEN, Lv, Shenzhen, Guangdong 518129 (CN); ZENG, Xiangyong, Shenzhen, Guangdong 518129 (CN)
(74) Representative: Gill Jennings & Every LLP
(86) International application number: PCT/CN2024/085544
(87) International publication number: WO 2024/250816

(57) **Abstract**

This application provides a computing device based on a phase-change liquid cooling technology, including a body, a jet component, and a power component. The body is divided into a first accommodation cavity and a second accommodation cavity through a partition plate. The first accommodation cavity is configured to accommodate a first coolant, the second accommodation cavity is configured to accommodate a heating element and a second coolant, and a temperature of the second coolant is higher than a temperature of the first coolant. The body is provided with a liquid refill opening communicating with the first accommodation cavity and an exhaust vent communicating with the second accommodation cavity. The power component is connected to the jet component, and is configured to pump the first coolant to the heating element through the jet component. In this application, a critical heat flux can be improved, and efficient jet cooling can be performed on the heating element with a high heat flux. In addition, the first accommodation cavity and the second accommodation cavity that are separated through the partition plate can respectively accommodate working media with different temperatures, to create an appropriate supercooling environment, avoid impact of cavitation on the power component, and ensure reliability and availability of the power component.

## Description

The present invention claims priorities to Chinese Patent Application No. 202310684677.0, filed with the China National Intellectual Property Administration on June 9, 2023, and entitled "SERVER PHASE-CHANGE IMMERSION JET COOLING SYSTEM", and to Chinese Patent Application No. 202311117502.8, filed with the China National Intellectual Property Administration on August 31, 2023, and entitled "COMPUTING DEVICE BASED ON PHASE-CHANGE LIQUID COOLING TECHNOLOGY", both of which are incorporated herein by reference in their entireties.

### TECHNICAL FIELD

This application relates to the field of heat dissipation technologies, and in particular, to a computing device based on a phase-change liquid cooling technology.

### BACKGROUND

With rapid development of density of a chip, a single-point heat dissipation problem of the chip becomes a focus. To resolve this problem, a phase-change immersion cooling technology is applied, that is, a heating element may be immersed in a phase-change working medium, and the phase-change working medium may boil under a normal pressure and near a normal temperature, and can cool the heating element by absorbing heat through evaporation.

However, an existing phase-change working medium is contained in a container, and a heat dissipation form of the phase-change working medium is a passive form. Consequently, a critical heat flux is low, local liquid shortage is easily caused, and a heat dissipation capability is limited.

### SUMMARY

An objective of this application is to provide a computing device based on a phase-change liquid cooling technology, to improve a critical heat flux and improve a heat dissipation capability through immersion and jet heat dissipation.

This application provides a computing device based on a phase-change liquid cooling technology, including a body, a jet component, and a power component. A partition plate is disposed in the body, space in the body is divided into a first accommodation cavity and a second accommodation cavity through the partition plate, the first accommodation cavity is configured to accommodate a first coolant, the second accommodation cavity is configured to accommodate a heating element and a second coolant, and a temperature of the second coolant is higher than a temperature of the first coolant. The body is provided with a liquid refill opening and an exhaust vent, the liquid refill opening communicates with the first accommodation cavity, and the exhaust vent communicates with the second accommodation cavity. A jet component is disposed in the second accommodation cavity. A power component is disposed in the first accommodation cavity, is connected to the jet component, and is configured to pump the first coolant into the jet component for jetting to the heating element through the jet component.

In this application, a working medium may be jetted to the heating element at a high speed through cooperation between the power component and the jet component, so that a critical heat flux can be greatly improved, and efficient jet cooling can be performed on the heating element like a CPU with a high heat flux. In addition, the first accommodation cavity and the second accommodation cavity that are separated through the partition plate may enable the power component to be disposed in the first coolant, and enable the heating element to be disposed in the second coolant, so that an appropriate supercooling environment can be created, impact of cavitation on the power component can be avoided, and reliability and availability of the power component can be ensured.

In a possible design, there is a gap between the top of the partition plate and the top of the body, and the gap may be used for circulation of the gaseous working medium, so that the gaseous working medium is discharged from the exhaust vent.

In a possible design, one end of the partition plate is connected to the bottom of the body, and the partition plate extends in a height direction of the body and is configured to separate the first accommodation cavity and the second accommodation cavity in a horizontal direction of the body. The partition plate may divide the body into the first accommodation cavity and the second accommodation cavity in the horizontal direction, so that the heat dissipation apparatus can be horizontally placed.

In a possible design, the first accommodation cavity and the second accommodation cavity are distributed in a height direction of the body. The body has a large height, and can be used in a vertical posture, so that a requirement in a special working environment can be met.

In a possible design, the partition plate includes a bottom plate and a side plate, the bottom plate is connected to both the side plate and a side wall of the body, and the first accommodation cavity is enclosed by the bottom plate, the side plate, and the side wall of the body. Space that is in the body and that is below the bottom plate forms the second accommodation cavity, so that the heat dissipation apparatus can be used in a vertical posture. This extends an application scenario of the heat dissipation apparatus.

In a possible design, the body is provided with a liquid overflow opening, the liquid overflow opening communicates with the second accommodation cavity, and a distance between the liquid overflow opening and the bottom of the body is less than a distance between the top of the partition plate and the bottom of the body. The side wall of the second accommodation cavity is provided with the liquid overflow opening, and a height of the liquid overflow opening is lower than a height of the partition plate. Therefore, when a liquid level in the second accommodation cavity rises to the liquid overflow opening, the second coolant may overflow from the liquid overflow opening, and no backflow occurs from the partition plate. In this way, it can be ensured that the first coolant extracted from the power component may have a specific supercooling degree. This helps create an appropriate supercooling environment and improve heat dissipation efficiency.

In a possible design, the partition plate and the body are integrally formed, that is, in a process of processing and manufacturing the body, the partition plate connected to the side wall of the body can be directly formed on the body. This can ensure reliability of an integrated structure of the body.

In a possible design, the partition plate is detachably connected to the body, so that a size specification of the partition plate is conveniently adjusted, to obtain the first accommodation cavity and the second accommodation cavity with different sizes.

In a possible design, the jet component includes a nozzle and a pipeline. The nozzle is disposed in the second accommodation cavity. The nozzle is provided with plurality of jet holes. One end of the pipeline is connected to the nozzle, and the other end of the pipeline is connected to the power component. The power component may pump the extracted first coolant in the second accommodation cavity into the nozzle through the pipeline. The coolant may be jetted to the corresponding heating element by the nozzle through the jet hole. Power provided by the power component may enable the first coolant jetted by the nozzle to have a high flow rate. Jetting the first coolant to the heating element at a high speed can greatly improve a boiling heat exchange coefficient and a critical heat flux, and can perform efficient jet cooling on the heating element like a CPU with a high heat flux.

In a possible design, the computing device further includes a first liquid level detection device. The first liquid level detection device is connected to the body, is disposed in the first accommodation cavity, and is configured to detect a first liquid level of the first coolant. A distance between the first liquid level detection device and the bottom of the body is greater than a distance between a liquid inlet of the power component and the bottom of the body. The first liquid level detection device may detect the first liquid level of the first coolant in the first accommodation cavity in real time, and can send a first detection signal to the controller. The controller controls opening and closing of a liquid supply valve based on the first detection signal, so that the working medium supplemented into the first accommodation cavity through the liquid refill opening can be maintained at the first liquid level in the first accommodation cavity at an expected position, and the expected position may be a position at which the liquid inlet of the power component can be immersed, to ensure that the power component can extract the first coolant through the liquid inlet.

In a possible design, the computing device further includes a second liquid level detection device. The second liquid level detection device is connected to the body, is disposed in the second accommodation cavity, and is configured to detect a second liquid level of the second coolant. A distance between the second liquid level detection device and the bottom of the body is greater than a distance between an upper surface of the heating element and the bottom of the body. The second liquid level detection device may be located above the heating element and is close to a position on the upper surface of the heating element. When the second liquid level is aligned with the second liquid level detection device in position, or when a height of the second liquid level is greater than a height of the second liquid level detection device, the second coolant can immerse the heating element. When the height of the second liquid level is lower than the height of the second liquid level detection device, a part of the heating element is exposed from the second coolant, and effective heat dissipation cannot be implemented. In this case, the second liquid level detection device may send a second detection signal, and the controller can control, based on the second detection signal, the liquid supply valve to have a large opening degree, so that the liquid level of the first coolant in the first accommodation cavity quickly rises, and the first coolant can overflow to the second accommodation cavity through the top of the partition plate, to supplement liquid into the second accommodation cavity. In this way, the liquid working medium in the second accommodation cavity can immerse the heating element. This implements effective heat dissipation.

In a possible design, the computing device further includes a third liquid level detection device. The third liquid level detection device is connected to the body, is disposed in the second accommodation cavity, and is configured to detect a third liquid level of the second coolant. A distance between the third liquid level detection device and the bottom of the body is greater than the distance between the second liquid level detection device and the bottom of the body, and the distance between the third liquid level detection device and the bottom of the body is less than or equal to the distance between the liquid overflow opening and the bottom of the body. When detecting the third liquid level, the third liquid level detection device may send a third detection signal, and the controller can control, based on the third detection signal, the liquid supply valve to be closed and stop supplementing liquid, to avoid a waste caused by overflow of the working medium from the liquid overflow opening.

In a possible design, the computing device further includes a liquid supply valve, and the liquid supply valve is connected to the liquid refill opening. The liquid supply valve can be electrically connected or signally connected to an external controller. The controller may control opening or closing of the liquid supply valve, and can adjust an opening degree of the liquid supply valve, to adjust a flow of the liquid working medium flowing through the liquid refill opening, so as to control the first liquid level of the first coolant in the first accommodation cavity.

In a possible design, the computing device further includes a condensation apparatus. The condensation apparatus is connected to the exhaust vent and is used for phase changing, through condensation, of the gaseous working medium output from the exhaust vent into a liquid working medium. A part of the second coolant that undergoes a phase change into gas through evaporation may enter the condensation apparatus through the exhaust vent, and can be condensed into liquid through the condensation apparatus. The working medium that is condensed into liquid may be recollected into the first accommodation cavity or collected into an external recycling apparatus, to recycle the coolant. This reduces consumption of the coolant, and reduces costs.

In a possible design, the computing device further includes a cabinet, and at least one body is mounted in the cabinet. The cabinet may internally have large space in the horizontal direction, so that the heat dissipation apparatus can be placed in the horizontal direction, and the first accommodation cavity and the second accommodation cavity in the heat dissipation apparatus can be distributed in the horizontal direction. In addition, the cabinet may internally have large space in the vertical direction, so that the heat dissipation apparatus can be placed in the vertical direction, and the first accommodation cavity and the second accommodation cavity in the heat dissipation apparatus can be distributed in the vertical direction.

It should be understood that the foregoing general descriptions and the following detailed descriptions are merely used as an example, and should not limit this application.

### BRIEF DESCRIPTION OF DRAWINGS

FIG. 1 is a diagram of a structure of a heat dissipation apparatus in a computing device based on a phase-change liquid cooling technology according to an embodiment of this application;
FIG. 2 is a diagram of a status of a heat dissipation apparatus in a computing device based on a phase-change liquid cooling technology during operating according to an embodiment of this application;
FIG. 3 is a diagram of a status of a heat dissipation apparatus in a computing device based on a phase-change liquid cooling technology operating in small and medium load working conditions according to an embodiment of this application;
FIG. 4 is a diagram of a status of a heat dissipation apparatus in a computing device based on a phase-change liquid cooling technology operating in a high load working condition according to an embodiment of this application;
FIG. 5 is a diagram of a structure of a heat dissipation apparatus in a computing device based on a phase-change liquid cooling technology according to another embodiment of this application; and
FIG. 6 is a diagram of a status of a heat dissipation apparatus in a computing device based on a phase-change liquid cooling technology during operating according to another embodiment of this application.

### Reference numerals:

1: body;
   11: first accommodation cavity;
   12: second accommodation cavity;
   13: liquid refill opening;
   14: exhaust vent;
   15: liquid overflow opening;
2: jet component;
   21: nozzle;
   22: pipeline;
3: power component;
4: partition plate;
   41: bottom plate;
   42: side plate;
5: gap;
6: first liquid level detection device;
7: second liquid level detection device;
8: third liquid level detection device;
A: first coolant;
B: second coolant;
100: heating element; and
Z: height direction.

The accompanying drawings herein are incorporated into this specification and constitute a part of this specification, to show embodiments in accordance with this application, and are used, together with this specification, to explain the principle of this application.

### DESCRIPTION OF EMBODIMENTS

To better understand technical solutions of this application, the following describes embodiments of this application in detail with reference to the accompanying drawings. It should be understood that the specific embodiments described herein are merely used to explain this application but are not intended to limit this application.

In descriptions of this application, unless otherwise specified and limited, the terms "first" and "second" are merely intended for a purpose of description, and cannot be understood as an indication or implication of relative importance. Unless otherwise specified or stated, the term "a plurality of" means two or more than two. The terms "connection", "fastening", and the like all should be understood in a broad sense. For example, "connection" may be a fastened connection, or may be a detachable connection, an integrated connection, or an electrical connection; or may be a direct connection, or may be an indirect connection through an intermediate medium. A person of ordinary skill in the art may understand specific meanings of the foregoing terms in this application based on specific cases.

For heat dissipation of a component with high heat emission, for example, a chip, a phase-change immersion cooling technology is generally considered for heat dissipation. During actual operation, a container containing a liquid phase-change working medium is usually used. The chip may be immersed in the working medium, heat of the chip may be transferred to the working medium, the liquid working medium absorbs heat and undergoes a phase change from liquid to gas, and heat of the chip may be absorbed in an evaporation phase-change process, to cool the chip.

However, a heat exchange capability of the liquid working medium generally has an upper limit, and the working medium has a critical heat flux (Critical Heat Flux, CHF). When an actual heat flux exceeds the critical heat flux, a large amount of gas generated by boiling of the liquid working medium hinders surrounding liquid from flowing to a heat dissipation surface of the chip, which causes a boiling heat transfer capability of the working medium to be greatly deteriorated. In addition, boiling heat transfer of the working medium in the container is a passive form, and is prone to local liquid shortage.

An embodiment of this application provides a computing device based on a phase-change liquid cooling technology (referred to as a computing device). The computing device includes a server and a heat dissipation apparatus. The server may be a cloud server, or may be a server of a distributed system, or a server with a blockchain combined, or the like. A plurality of electronic components are integrated in the server. Some electronic components, for example, a chip, a graphics processing unit (Graphics Processing Unit, GPU), a graphics card, and a memory module, have high heat emission. These electronic components that generate a large amount of heat may be used as heating elements in embodiments of this application. In addition, the foregoing listed electronic components that generate a large amount of heat are not used as a limitation on the heating element provided in embodiments of this application. In an embodiment, the heating element may alternatively be a component that has a high heat emission and that includes a component like a chip. In addition, the computing device includes a cabinet. The cabinet may be used as a housing of a server. The heat dissipation apparatus may be disposed in the cabinet, and is configured to dissipate heat of the heating element. In an embodiment, the cabinet may have at least one mounting portion, and the heat dissipation apparatus may be mounted on the mounting portion. When there are a plurality of mounting portions, there may also be a plurality of heat dissipation apparatuses, and the heat dissipation apparatuses are mounted on corresponding mounting portions one by one. In an embodiment, the mounting portion may be of a slot structure, so that the heat dissipation apparatus can be fastened to and embedded in the slot structure. This facilitates mounting of the heat dissipation apparatus and ensures mounting stability of the heat dissipation apparatus. Certainly, a structure of the mounting portion is not limited to the slot structure, and may alternatively be a partial area on the cabinet. The heat dissipation apparatus may be mounted on the mounting portion through a connecting member like a screw.

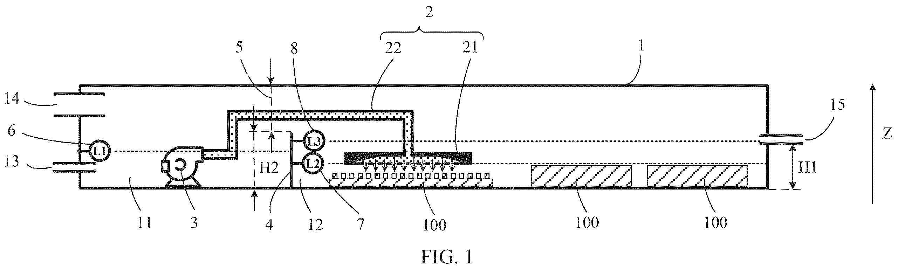

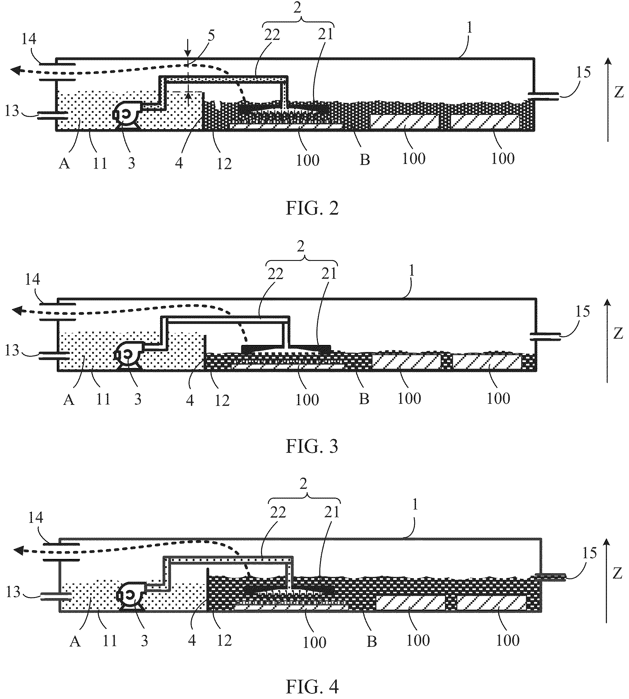

In an embodiment, FIG. 1 is a diagram of a structure of a heat dissipation apparatus in a computing device based on a phase-change liquid cooling technology according to an embodiment of this application. FIG. 2 is a diagram of a status of the heat dissipation apparatus in the computing device based on a phase-change liquid cooling technology during operating according to an embodiment of this application. Refer to FIG. 1 and FIG. 2. The heat dissipation apparatus includes a body 1. There is space in the body 1, and a partition plate 4 is disposed in the body 1. The space in the body 1 may be divided into a first accommodation cavity 11 and a second accommodation cavity 12 through a partition plate 4. The first accommodation cavity 11 and the second accommodation cavity 12 does not communicate with each other. The first accommodation cavity 11 is configured to accommodate a first coolant A, and the second accommodation cavity 12 is configured to accommodate a heating element 100 and a second coolant B. The heating element 100 may be placed in the second accommodation cavity 12 and is immersed in the second coolant B. Heat of the heating element 100 may be transferred to the second coolant B, so that the second coolant B has a high temperature. The first coolant A in the first accommodation cavity 11 does not contact the heating element 100, and may be separated from the second coolant B in the second accommodation cavity 12 through the partition plate 4, so that the first coolant A has a low temperature. That is, the temperature of the first coolant A is lower than the temperature of the second coolant B.

The body 1 is provided with a liquid refill opening 13. The liquid refill opening 13 communicates with the first accommodation cavity 11, and a liquid working medium may be filled into the first accommodation cavity 11 through the liquid refill opening 13. The filled liquid working medium may be referred to as the first coolant A in the first accommodation cavity 11. If the first coolant A in the first accommodation cavity 11 is input into the second accommodation cavity 12, after the first coolant A that enters the second accommodation cavity 12 from the first accommodation cavity 11 is mixed with the original second coolant B in the second accommodation cavity 12, the temperature is assimilated. In this case, all the liquid working medium in the second accommodation cavity 12 may be referred to as the second coolant B. That is, the coolant in the first accommodation cavity 11 and the coolant in the second accommodation cavity 12 are the same liquid working medium, and a difference lies in that the temperature of the second coolant B in the second accommodation cavity 12 is higher than the temperature of the first coolant A in the first accommodation cavity 11.

The body 1 is provided with an exhaust vent 14, and the exhaust vent 14 communicates with the second accommodation cavity 12. After absorbing heat from the heating element 100, the second coolant B in the second accommodation cavity 12 boils, so that a part of the second coolant B undergoes a phase change into gas. The gaseous working medium may be discharged from the exhaust vent 14 to the outside of the second accommodation cavity 12, to ensure stability of pressure in the second accommodation cavity 12. In an embodiment, the computing device further includes a condensation apparatus. The condensation apparatus is connected to the exhaust vent 14 and is for phase changing, through condensation, of the gaseous working medium output from the exhaust vent 14 to a liquid working medium. That is, a part of the second coolant B that undergoes a phase change into gas through evaporation may enter the condensation apparatus through the exhaust vent 14, and can be condensed into liquid through the condensation apparatus. The working medium that is condensed into liquid may be recollected into the first accommodation cavity 11 or collected into an external recycling apparatus, to recycle the coolant. This reduces consumption of the coolant, and reduces costs.

The computing device further includes a power component 3. The power component 3 may be an apparatus like a water pump or a hydraulic pump, and can extract the first coolant A in the first accommodation cavity 11 for jetting to the heating element 100 in the second accommodation cavity 12 through the jet component 2.

The jet component 2 may be a jet nozzle, a jet orifice plate, or the like. For example, the jet component 2 includes a nozzle 21 and a pipeline 22. The nozzle 21 is disposed in the second accommodation cavity 12. The nozzle 21 is provided with plurality of jet holes. One end of the pipeline 22 is connected to the nozzle 21, and the other end of the pipeline 22 is connected to the power component 3. The power component 3 may pump the extracted first coolant A in the second accommodation cavity 12 into the nozzle 21 through the pipeline 22. The coolant may be jetted to the corresponding heating element 100 by the nozzle 21 through the jet hole. Power provided by the power component 3 may enable the first coolant A jetted by the nozzle 21 to have a high flow rate. Jetting the first coolant A to the heating element 100 at a high speed can greatly improve a boiling heat exchange coefficient and a critical heat flux, and can perform efficient jet cooling on the heating element 100 like a CPU with a high heat flux.

In addition, if it is considered that the power component 3 like a pump, the jet component 2, the heating element 100, and a liquid working medium are jointly placed in a container having only a unique accommodation cavity, the pump may extract the liquid working medium for jetting to the heating element 100 through the jet component 2, to implement an internal circulation jet cooling manner. However, because the liquid working medium continuously exchanges heat with the heating element 100, the liquid working medium in the container is near-saturated, and the new working medium added to the container may be assimilated by the near-saturated working medium in the container soon. When the pump directly extracts the near-saturated working medium, the working medium is prone to cavitation due to gasification under negative pressure. This may significantly affect performance of the pump. Reliability of the pump may also be greatly reduced due to impact of cavitation on an impeller in the pump.

Therefore, in this embodiment, the first accommodation cavity 11 and the second accommodation cavity 12 that are separated from each other are provided in the body 1, and the first coolant A that enters the first accommodation cavity 11 from the liquid refill opening 13 does not directly contact the second coolant B and the heating element 100 in the second accommodation cavity 12, so that the working medium extracted by the power component 3 located in the first accommodation cavity 11 has a specific supercooling degree, and the supercooling degree can be matched based on cavitation margin required by the power component 3. In this way, an appropriate working environment can be created, to effectively avoid impact of cavitation on the power component 3, and ensure reliability and availability of the power component 3.

Therefore, the computing device based on a phase-change liquid cooling technology provided in this embodiment of this application may jet the working medium to the heating element 100 at a high speed through cooperation between the power component 3 and the jet component 2, so that a critical heat flux can be greatly improved, and efficient jet cooling can be performed on the heating element 100 like a CPU with a high heat flux. In addition, the first accommodation cavity 11 and the second accommodation cavity 12 that are separated through the partition plate 4 may enable the power component 3 to be disposed in the first coolant A, and enable the heating element 100 to be disposed in the second coolant B, so that an appropriate supercooling environment can be created, impact of cavitation on the power component 3 can be avoided, and reliability and availability of the power component 3 can be ensured.

In an embodiment, the body 1 and the partition plate 4 may be of an integrated structure, that is, in a process of processing and manufacturing the body 1, the partition plate 4 may be formed at the same time, and the first accommodation cavity 11 and the second accommodation cavity 12 may be separated from the body 1 through the partition plate 4, to simplify the structure, facilitate processing and manufacturing of the body 1 and the partition plate 4, and ensure overall reliability of the structure. In addition, in some other embodiments, the partition plate 4 may alternatively be detachably connected to the body 1, so that a size specification of the partition plate 4 can be conveniently adjusted, to obtain the first accommodation cavity 11 and the second accommodation cavity 12 with different sizes.

In an embodiment, refer to FIG. 1. There is a gap 5 between the top of the partition plate 4 and the top of the body 1. The top of the body 1 may be of a closed structure. For example, the top of the body 1 has a cover plate, and there is a gap 5 between an inner side surface of the cover plate and the top of the partition plate 4. The gap 5 may be used for circulation of the gaseous working medium. In an embodiment, both the exhaust vent 14 and the liquid refill opening 13 may be provided on a same side of the body 1. For example, both the exhaust vent 14 and the liquid refill opening 13 are provided on a side wall of the first accommodation cavity 11, and the gaseous working medium obtained through phase-changing of the second coolant B may flow to the exhaust vent 14 through the gap 5 between the top of the body 1 and the top of the partition plate 4, and may be discharged through the exhaust vent 14. In a design in which the exhaust vent 14 and the liquid refill opening 13 are located on the same side of the body 1, the exhaust vent 14 and the liquid refill opening 13 may be closer to each other, so that after the gaseous working medium at the exhaust vent 14 is condensed, the liquid working medium obtained through condensation can be quickly conveyed to the external recycling apparatus or supplemented into the first accommodation cavity 11. In some other embodiments, the exhaust vent 14 may alternatively be disposed on a side wall of the second accommodation cavity 12, so that a path for discharging the gaseous working medium obtained through phase-changing of the second coolant B from the exhaust vent 14 can be shortened. This helps quickly discharge the gaseous working medium from the exhaust vent 14, and helps maintain stability of pressure in the body 1. In some other embodiments, the exhaust vent 14 may alternatively be disposed on the cover plate on the top of the body 1. This is not limited in this embodiment.

In this embodiment, FIG. 3 is a diagram of a status of the heat dissipation apparatus in the computing device based on a phase-change liquid cooling technology operating in small and medium load working conditions according to an embodiment of this application. Refer to FIG. 3. The gap 5 between the top of the body 1 and the top of the partition plate 4 may be further used for the liquid working medium to flow from the first accommodation cavity 11 to the second accommodation cavity 12. Specifically, when a liquid level of the second coolant B in the second accommodation cavity 12 is low, and a liquid working medium needs to be supplemented, the first coolant A may be supplemented into the first accommodation cavity 11 through the liquid refill opening 13, so that a liquid level of the first coolant A increases, and the first coolant A can automatically overflow to the second accommodation cavity 12 through the top of the partition plate 4. In this way, the second accommodation cavity 12 can be supplemented with a small flow, and a basic balance can be achieved between an amount of refilled liquid and an amount of the second coolant B that undergoes a phase change into gas, so that a waste of a working medium flow can be reduced while a heat dissipation effect is ensured. In the case of supplementing liquid with a small flow, the power component 3 may stop operating. This saves energy consumption and reduces costs.

In addition, FIG. 4 is a diagram of a status of the heat dissipation apparatus in the computing device based on a phase-change liquid cooling technology operating in a high load working condition according to an embodiment of this application. Refer to FIG. 4. When density of the heating element 100 is high, and it is difficult to implement effective heat dissipation by using the manner of supplementing liquid with a small flow, a large amount of the first coolant A in the first accommodation cavity 11 may be jetted to the heating element 100 at a high speed through cooperation between the power component 3 and the jet component 2, so that a critical heat flux can be greatly improved, and efficient heat dissipation of the heating element 100 with a high density can be implemented. A pipeline 22 of the jet component 2 may cross the partition plate 4 from the gap 5 between the top of the partition plate 4 and the top of the body 1, so that the power component 3 located in the first accommodation cavity 11 may be connected to the nozzle 21 located in the second accommodation cavity 12 through the pipeline 22.

In this embodiment, for a liquid supplement operation in the second accommodation cavity 12, the first coolant A in the first accommodation cavity 11 may overflow from the top of the partition plate 4 to supplement liquid to the second accommodation cavity 12, and the power component 3 and the jet component 2 may not need to participate in working. The power component 3 and the jet component 2 may choose to start working only when the heating element 100 has a high density, to perform jet heat dissipation. In this way, liquid supplement work of the second accommodation cavity 12 can be decoupled from jet heat dissipation work, and liquid supplement does not need to be performed through the power component 3 and the jet component 2. This reduces energy consumption.

In an embodiment, refer to FIG. 1. One end of the partition plate 4 is connected to the bottom of the body 1, and the partition plate 4 extends in a height direction Z of the body 1, and is configured to separate the first accommodation cavity 11 and the second accommodation cavity 12 in a horizontal direction of the body 1. In this embodiment, the heat dissipation apparatus may be horizontally placed, and the partition plate 4 may divide the body 1 into the first accommodation cavity 11 and the second accommodation cavity 12 in the horizontal direction. A shape of a cross section of the body 1 may be a regular polygon, a circle, an ellipse, an abnormal shape, or the like. In this embodiment, the body 1 may be in a shape of a cuboid, and the cuboid has a length, a width, and a height. The horizontal direction of the body 1 may be a length direction or a width direction of the body 1.

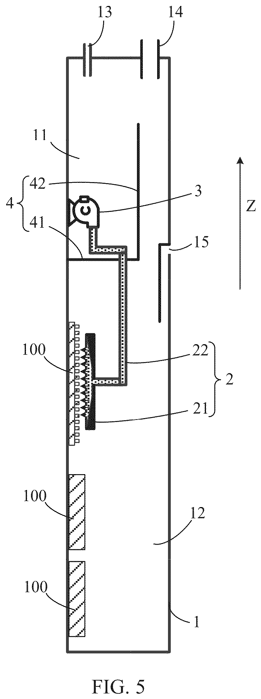

In an embodiment, FIG. 5 is a diagram of a structure of the heat dissipation apparatus in the computing device based on a phase-change liquid cooling technology according to another embodiment of this application. Refer to FIG. 5. The first accommodation cavity 11 and the second accommodation cavity 12 may be distributed in the height direction Z of the body 1. In this embodiment, the body 1 has a large height, and can be used in a vertical posture, so that a requirement in a special working environment can be met. In this embodiment, a working principle of the heat dissipation apparatus used in the vertical posture is similar to that of the heat dissipation apparatus used in a horizontal posture. Details are not described herein again.

In an embodiment, refer to FIG. 5. The partition plate 4 includes a bottom plate 41 and a side plate 42. The bottom plate 41 is connected to both the side plate 42 and a side wall of the body 1. The first accommodation cavity 11 is enclosed by the bottom plate 41, the side plate 42, and the side wall of the body 1. Space that is in the body 1 and that is located below the bottom plate 41 forms the second accommodation cavity 12.

In this embodiment, the partition plate 4 including the bottom plate 41 and the side plate 42 can separate the first accommodation cavity 11 and the second accommodation cavity 12 in the height direction Z of the body 1, so that the heat dissipation apparatus can be used in the vertical posture. This extends an application scenario of the heat dissipation apparatus. The partition plate 4 and the body 1 may be of an integrated structure, that is, in a process of processing and manufacturing the body 1, the partition plate 4 connected to the side wall of the body 1 can be directly formed on the body 1. This can ensure reliability of an integrated structure of the body 1. In addition, in some other embodiments, the partition plate 4 may alternatively be detachably connected to the body 1, so that a size specification of the partition plate 4 is conveniently adjusted, to obtain the first accommodation cavity 11 and the second accommodation cavity 12 with different sizes.

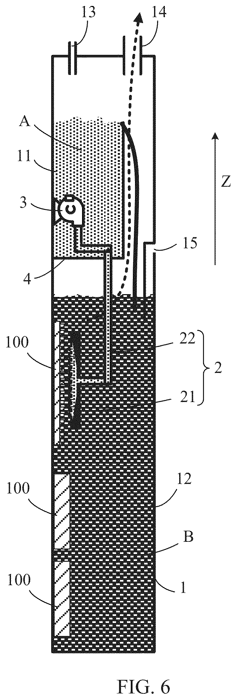

FIG. 6 is a diagram of a status of the heat dissipation apparatus in the computing device based on a phase-change liquid cooling technology during working according to another embodiment of this application. Refer to FIG. 6. In a working process of the heat dissipation apparatus having the first accommodation cavity 11 and the second accommodation cavity 12 that are provided in the height direction Z of the body 1, the heating element 100 may be immersed in the second coolant B in the second accommodation cavity 12 located below. The heating element 100 may be fastened to a side wall of the second accommodation cavity 12, or may be placed at the bottom of the second accommodation cavity 12. The power component 3 may be mounted on a side wall of the first accommodation cavity 11, or may be mounted on the bottom plate 41, or may be mounted on the side plate 42. The nozzle 21 of the jet component 2 is disposed in the second accommodation cavity 12, and can be aligned with the to-be-dissipated heating element 100 in position, so that the jetted working medium can directly impact the heating element 100.

For example, refer to FIG. 6. The pipeline 22 of the jet component 2 may pass through the bottom plate 41. Specifically, the bottom plate 41 may be provided with a hole, the pipeline 22 can pass through the hole, and a sealing member may be used to seal the pipeline 22 and the hole. For example, the pipeline 22 may also bypass the bottom of the side plate 42. This is not limited in this embodiment.

The first coolant A in the first accommodation cavity 11 located above may overflow from the top of the side plate 42 to the second accommodation cavity 12 located below, to supplement liquid to the second accommodation cavity 12 with a small flow.

In an embodiment, refer to FIG. 1. The body 1 is provided with a liquid overflow opening 15, the liquid overflow opening 15 communicates with the second accommodation cavity 12, and a distance H1 between the liquid overflow opening 15 and the bottom of the body 1 is less than a distance H2 between the top of the partition plate 4 and the bottom of the body 1.

With reference to FIG. 4, when the working medium is jetted into the second accommodation cavity 12 through only the jet component 2, or with reference to FIG. 2, when the working medium is jetted into the second accommodation cavity 12 through the jet component 2 and the working medium overflows into the second accommodation cavity 12 through the top of the partition plate 4, and when an amount of the gasified second coolant B in the second accommodation cavity 12 is less than an amount of the second coolant B jetted through the jet component 2, or when an amount of the gasified second coolant B in the second accommodation cavity 12 is less than an amount of the second coolant B jetted through the jet component 2 and an amount of the second coolant B overflowing from the top of the partition plate 4, a liquid level in the second accommodation cavity 12 gradually rises. If no liquid overflow opening 15 is provided, the gradually rising liquid level finally causes backflow from the partition plate 4, that is, the second coolant B in the second accommodation cavity 12 flows back to the first accommodation cavity 11, and is mixed with the first coolant A in the first accommodation cavity 11, and the first coolant A is assimilated. This damages a supercooling environment.

Therefore, in this embodiment, the side wall of the second accommodation cavity 12 is provided with a liquid overflow opening 15, and a height of the liquid overflow opening 15 is lower than a height of the partition plate 4. Therefore, when the liquid level in the second accommodation cavity 12 rises to the liquid overflow opening 15, the second coolant B may overflow from the liquid overflow opening 15, and no backflow occurs from the partition plate 4. In this way, it can be ensured that the first coolant A extracted from the power component 3 may have a specific supercooling degree. This helps create an appropriate supercooling environment and improve heat dissipation efficiency.

In an embodiment, refer to FIG. 1. The computing device further includes a first liquid level detection device 6. The first liquid level detection device 6 is connected to the body 1, is disposed in the first accommodation cavity 11, and is configured to detect a first liquid level of the first coolant A. The first liquid level detection device 6 may be a liquid level sensor, for example, a pontoon liquid level sensor, a floating-ball liquid level sensor, or a static pressure liquid level sensor.

A liquid supply valve may be connected to the liquid refill opening 13, and the liquid supply valve can be electrically connected or signally connected to an external controller. The controller may control opening or closing of the liquid supply valve, and can adjust an opening degree of the liquid supply valve, to adjust a flow of the liquid working medium flowing through the liquid refill opening 13, so as to control the first liquid level of the first coolant A in the first accommodation cavity 11. Specifically, the first liquid level detection device 6 may detect the first liquid level of the first coolant A in the first accommodation cavity 11 in real time, and can send a first detection signal to the controller. The controller controls opening and closing, and an opening degree of the liquid supply valve based on the first detection signal, so that the working medium supplemented into the first accommodation cavity 11 through the liquid refill opening 13 can be maintained at the first liquid level in the first accommodation cavity 11 at an expected position, and the expected position may be a position at which a liquid inlet of the power component 3 can be immersed, to ensure that the power component 3 can extract the first coolant A through the liquid inlet. In this embodiment, a distance between the first liquid level detection device 6 and the bottom of the body 1 is greater than a distance between the liquid inlet of the power component 3 and the bottom of the body 1, so that when a height of the first liquid level is lower than a height of the first liquid level detection device 6, the first liquid level detection device 6 may send the first detection signal, to supplement liquid into the first accommodation cavity 11 by controlling the liquid supply valve by the controller, so as to ensure that the first coolant A in the first accommodation cavity 11 can immerse the liquid inlet of the power component 3.

In an embodiment, the computing device further includes a second liquid level detection device 7. The second liquid level detection device 7 is connected to the body 1, is disposed in the second accommodation cavity 12, and is configured to detect a second liquid level of the second coolant B. A distance between the second liquid level detection device 7 and the bottom of the body 1 is greater than a distance between an upper surface of the heating element 100 and the bottom of the body 1.

The second liquid level detection device 7 may be a liquid level sensor the same as the first liquid level detection device 6, and may also be electrically connected or signally connected to the controller. The second liquid level detection device 7 may be located above the heating element 100 and is close to a position on the upper surface of the heating element 100. When the second liquid level is aligned with the second liquid level detection device 7 in position, or when a height of the second liquid level is greater than a height of the second liquid level detection device 7, the second coolant B can immerse the heating element 100. When the height of the second liquid level is lower than the height of the second liquid level detection device 7, a part of the heating element 100 is exposed from the second coolant B, and effective heat dissipation cannot be implemented. In this case, the second liquid level detection device 7 may send a second detection signal, and the controller can control, based on the second detection signal, the liquid supply valve to have a large opening degree, so that the liquid level of the first coolant A in the first accommodation cavity 11 quickly rises, and the first coolant A can overflow to the second accommodation cavity 12 through the top of the partition plate 4, to supplement liquid into the second accommodation cavity 12. In this way, the liquid working medium in the second accommodation cavity 12 can immerse the heating element 100. This implements effective heat dissipation.

In an embodiment, the computing device further includes a third liquid level detection device 8. The third liquid level detection device 8 is connected to the body 1, is disposed in the second accommodation cavity 12, and is configured to detect a third liquid level of the second coolant B. A distance between the third liquid level detection device 8 and the bottom of the body 1 is greater than the distance between the second liquid level detection device 7 and the bottom of the body 1, and the distance between the third liquid level detection device 8 and the bottom of the body 1 is less than or equal to the distance between the liquid overflow opening 15 and the bottom of the body 1.

The third liquid level detection device 8 may be a liquid level sensor the same as the first liquid level detection device 6 and the second liquid level detection device 7, and may also be electrically connected or signally connected to the controller. The third liquid level detection device 8 may be located at a position at a same height as the liquid overflow opening 15, or at a position slightly lower than the liquid overflow opening 15. When the third liquid level reaches a position of the third liquid level detection device 8, it indicates that if liquid is continuously supplemented into the second accommodation cavity 12, the second coolant B in the second accommodation cavity 12 is about to overflow from the liquid overflow opening 15, causing a waste of the working medium. When detecting the third liquid level, the third liquid level detection device 8 may send a third detection signal, and the controller can control, based on the third detection signal, the liquid supply valve to be closed and stop supplementing liquid, to avoid a waste caused by overflow of the working medium from the liquid overflow opening 15.

The foregoing descriptions are merely preferred embodiments of this application and are not intended to limit this application. For a person skilled in the art, this application may have various modifications and changes. Any modification, equivalent replacement, or improvement made without departing from the spirit and principle of this application shall fall within the protection scope of this application.

## Claims

1. A computing device based on a phase-change liquid cooling technology, comprising:
a body (1), wherein a partition plate is disposed in the body (1), space in the body (1) is divided into a first accommodation cavity (11) and a second accommodation cavity (12) through the partition plate, the first accommodation cavity (11) is configured to accommodate a first coolant (A), the second accommodation cavity (12) is configured to accommodate a heating element (100) and a second coolant (B), a temperature of the second coolant (B) is higher than a temperature of the first coolant (A), the body (1) is provided with a liquid refill opening (13) and an exhaust vent (14), the liquid refill opening (13) communicates with the first accommodation cavity (11), and the exhaust vent (14) communicates with the second accommodation cavity (12);
a jet component (2), disposed in the second accommodation cavity (12); and
a power component (3), disposed in the first accommodation cavity (11), connected to the jet component (2), and configured to pump the first coolant (A) into the jet component (2) for jetting to the heating element (100) through the jet component (2).

2. The computing device based on a phase-change liquid cooling technology according to claim 1, wherein there is a gap (5) between a top of the partition plate (4) and a top of the body (1).

3. The computing device based on a phase-change liquid cooling technology according to claim 1 or 2, wherein one end of the partition plate (4) is connected to a bottom of the body (1), and the partition plate (4) extends in a height direction (Z) of the body (1) and is configured to separate the first accommodation cavity (11) and the second accommodation cavity (12) in a horizontal direction of the body (1).

4. The computing device based on a phase-change liquid cooling technology according to claim 1, wherein the first accommodation cavity (11) and the second accommodation cavity (12) are distributed in a height direction (Z) of the body (1).

5. The computing device based on a phase-change liquid cooling technology according to claim 4, wherein the partition plate (4) comprises a bottom plate (41) and a side plate (42), the bottom plate (41) is connected to both the side plate (42) and a side wall of the body (1), and the first accommodation cavity (11) is enclosed by the bottom plate (41), the side plate (42), and the side wall of the body (1); and
space that is in the body (1) and that is located below the bottom plate (41) forms the second accommodation cavity (12).

6. The computing device based on a phase-change liquid cooling technology according to any one of claims 1 to 5, wherein the body (1) is provided with a liquid overflow opening (15), the liquid overflow opening (15) communicates with the second accommodation cavity (12), and a distance between the liquid overflow opening (15) and the bottom of the body (1) is less than a distance between the top of the partition plate (4) and the bottom of the body (1).

7. The computing device based on a phase-change liquid cooling technology according to any one of claims 1 to 6, wherein the partition plate (4) and the body (1) are integrally formed.

8. The computing device based on a phase-change liquid cooling technology according to any one of claims 1 to 6, wherein the partition plate (4) is detachably connected to the body (1).

9. The computing device based on a phase-change liquid cooling technology according to any one of claims 1 to 7, wherein the jet component (2) comprises a nozzle (21) and a pipeline (22), the nozzle (21) is disposed in the second accommodation cavity (12), the nozzle (21) is provided with a plurality of jet holes, one end of the pipeline (22) is connected to the nozzle (21), and the other end of the pipeline (22) is connected to the power component (3).

10. The computing device based on a phase-change liquid cooling technology according to any one of claims 1 to 9, further comprising a first liquid level detection device (6), wherein the first liquid level detection device (6) is connected to the body (1), is disposed in the first accommodation cavity (11), and is configured to detect a first liquid level of the first coolant (A); and
a distance between the first liquid level detection device (6) and the bottom of the body (1) is greater than a distance between a liquid inlet of the power component (3) and the bottom of the body (1).

11. The computing device based on a phase-change liquid cooling technology according to claim 6, further comprising a second liquid level detection device (7), wherein the second liquid level detection device (7) is connected to the body (1), is disposed in the second accommodation cavity (12), and is configured to detect a second liquid level of the second coolant (B); and
a distance between the second liquid level detection device (7) and the bottom of the body (1) is greater than a distance between an upper surface of the heating element (100) and the bottom of the body (1).

12. The computing device based on a phase-change liquid cooling technology according to claim 11, further comprising a third liquid level detection device (8), wherein the third liquid level detection device (8) is connected to the body (1), is disposed in the second accommodation cavity (12), and is configured to detect a third liquid level of the second coolant (B); and
a distance between the third liquid level detection device (8) and the bottom of the body (1) is greater than the distance between the second liquid level detection device (7) and the bottom of the body (1), and the distance between the third liquid level detection device (8) and the bottom of the body (1) is less than or equal to the distance between the liquid overflow opening (15) and the bottom of the body (1).

13. The computing device based on a phase-change liquid cooling technology according to any one of claims 1 to 12, further comprising a liquid supply valve, wherein the liquid supply valve is connected to the liquid refill opening (13).

14. The computing device based on a phase-change liquid cooling technology according to any one of claims 1 to 13, further comprising a condensation apparatus, wherein the condensation apparatus is connected to the exhaust vent (14), and is used for phase changing, through condensation, of a gas working medium output from the exhaust vent (14) into a liquid working medium.

15. The computing device based on a phase-change liquid cooling technology according to any one of claims 1 to 14, further comprising a cabinet, wherein at least one body is mounted in the cabinet.
